# EUROPEAN PATENT SPECIFICATION

(11) **EP 2 950 450 B1**
(45) Date of publication and mention of the grant of the patent: **27.02.2019**
(21) Application number: 14169881.1
(22) Date of filing: 26.05.2014
(51) Int. Cl.: H03K 17/16, H01H 9/56, H03K 17/28

(54) **Method for point on wave switching and controller therefor**
Verfahren zur Schaltung auf der Spannungswelle und eine Steuerung dafür
Procédé pour point de commutation d'onde et contrôleur associé

(43) Date of publication of application: 02.12.2015
(73) Proprietor: ABB Schweiz AG, 5400 Baden (CH)
(72) Inventor: Parapurath, Anoop, 670005 Kerala (IN); Talluri, Anil, 560103 Bangalore (IN)
(74) Representative: Zimmermann & Partner Patentanwälte mbB

(56) References cited:
- EP-A2- 2 237 296
- WO-A1-02/15351
- WO-A1-2012/152829
- US-A- 5 132 867
- CRAIG WESTER ET AL: "IEC61850 protocol - practical applications in industrial facilities", INDUSTRY APPLICATIONS SOCIETY ANNUAL MEETING (IAS), 2011 IEEE, IEEE, 9 October 2011 (2011-10-09), pages 1-7, XP032069066, DOI: 10.1109/IAS.2011.6074474 ISBN: 978-1-4244-9498-9

## Description

### FIELD OF THE INVENTION

The present invention relates to point on wave controllers. More particularly, the present invention relates to point on wave controllers employed on transfer bays.

### BACKGROUND

In power systems, circuit breakers are used for connecting and disconnecting a load. During this process, the active elements of the circuit breaker either interrupt or incept high current, causing stresses in the circuit breaker as well as the connected power system components. The flow of the high current can be limited by closing and opening the circuit breaker at a specific instance on the source voltage waveform. A plurality of techniques are known for controlling the opening or closing of the circuit breaker in order to prevent generation of transient phenomenon. Such techniques rely on the usage of devices that perform synchronized switching control. One such device is the point on wave controller. Document US 5,132,867 A discloses a microprocessor based tie relay which controls a tie circuit breaker between a main bus and a transfer bus to which a number of feed lines may be connected through a disconnect switch when the feeder circuit breaker associated with the feeder line is out of service. Document WO 2012/152829 A1 discloses a point-on-wave controller for network synchronous switching of a circuit breaker device in an AC power transmission network. The document "IEC61850 protocol - practical applications in industrial facilities" by Craig Wester et. al., in: Industry applications society annual meeting, 2011, IEEE, 9 October 2011, pages 1-7, discloses fundamentals and practical applications of the IEC61850 protocol. A zone interlocking protection scheme, a main-tie-main bus transfer scheme and a load schedding theme are mentioned.

Point on wave controller is used for controlling switching instance of the circuit breaker. On receiving a command from a bay control unit, the point on wave controller advances the command to achieve closing or opening at an instance to minimize the current, depending on the load connected, considering all the delay caused till the primary contact of the circuit breaker is closed or separated depending, whether it is close or open operation. The point on wave controller detects the opening or closing actuation time (also referred to as operating time) of the circuit breaker and calculates a time for switching in respect of the opening or closure command signal of the circuit breaker to ensure switching on a particular point on the voltage waveform. Based on calculated time the point on wave controller controls the output timing of the opening or closure command signal. For calculating the synchronization delay time, the point on wave controller utilizes a plurality of inputs such as load characteristics, source voltage, source current, load voltage, ambient temperature, drive pressure of the circuit breaker, etc. By observing the source voltage, point on wave controller, predicts the future points on the source voltage waveform and accordingly release the open or close command the operating coils to the circuit breaker.

Now a days, there is an increasing demand for using point on wave controllers for charging and discharging of static loads, such as reactors, capacitors, etc., and for energizing and de-energizing equipment such as transformers, lines, etc. so as to ensure proper switching operations. Due to this increasing demand, point on wave controllers are being used across all the bays of the power system including the transfer bay. However, currently the accuracy of the point on wave controller present on the transfer bay is lower than those of the point on wave controllers connected to the bays. Additionally, point on wave switching on the transfer bay is procedurally complex. Therefore, when a load is transferred to the transfer bay, often improper switching operation occurs causing a reduction in the life expectancy of the circuit breaker.

Therefore, in light of the abovementioned discussion, there is a need for a method and system that satisfies the above mentioned problems.

### BRIEF DESCRIPTION OF THE INVENTION

The above-mentioned shortcomings, disadvantages and problems are addressed herein which will be understood by reading and understanding the following specification. A method according to claim 1 and a controller for operating a circuit breaker according to the independent device claim are disclosed.

In one aspect, the present disclosure provides a method of performing point on wave switching in a multiphase electrical system having a first circuit breaker connected to a first bus, the first circuit breaker operated by a first controller, a second circuit breaker connected to a second bus, the second circuit breaker operated by a second controller, and a subsystem transferred from the first bus to the second bus. The method includes receiving by the second controller, system characteristics data of the subsystem, estimating by the second controller, a time for switching based on the received system characteristics data of the subsystem and operating time of the second circuit breaker and operating by the second controller the second circuit breaker at the estimated time for switching, for switching the subsystem.

In an embodiment, the method further includes subscribing by the second controller to a data stream of a measurement sensor associated with the subsystem upon receiving the system characteristics data. In an embodiment, the system characteristics data is transmitted from one or more subsystem data sources, upon receiving a signal from at least one of an isolator and an operator. In an embodiment, wherein the one or more subsystem data sources includes the first controller. In another embodiment, the one or more subsystem data sources includes a central data repository. The central data repository is communicatively coupled to one or more controllers for receiving switching information from the one or more controllers.

In another aspect, the present invention provides a controller for operating a circuit breaker connected to a second bus for switching a subsystem. The subsystem is transferred from a first bus to a second bus. The controller has one or more processors configured to receive system characteristics data of the subsystem, estimate a time for switching based on the received system characteristics data of the subsystem and operating time of the circuit breaker, and operate the circuit breaker (197) at the estimated time for switching, for switching the subsystem, and a memory module functionally coupled to the one or more processors.

In an embodiment, the one or more processors are further configured to subscribe a data stream of a measurement sensor associated with the subsystem. In an embodiment, the controller further includes a network interface configured to communicate over an IEC 61850 channel for receiving the system characteristics data from one or more system data sources.
In an embodiment, the one or more system data sources includes at least one of a first controller functionally coupled to a circuit breaker of the first bus and a central repository.

Systems and methods of varying scope are described herein. In addition to the aspects and advantages described in this summary, further aspects and advantages will become apparent by reference to the drawings and with reference to the detailed description that follows.

### BRIEF DESCRIPTION OF THE DRAWINGS

Figure 1 illustrates a typical single line representation of a multiphase electrical system, in accordance with various embodiments of the present invention;
Figure 2 is a flowchart of a method for performing point on wave switching in the multiphase electrical system using a second controller, in accordance with various embodiments of the present invention; and
Figure 3 illustrates a multiphase electrical system with one or more measurement sensors, in accordance with various embodiments of the present invention.

### DETAILED DESCRIPTION

In the following detailed description, reference is made to the accompanying drawings that form a part hereof, and in which is shown by way of illustration specific embodiments, which may be practiced. These embodiments are described in sufficient detail to enable those skilled in the art to practice the embodiments, and it is to be understood that other embodiments may be utilized and that logical, mechanical, electrical and other changes may be made without departing from the scope of the embodiments. The following detailed description is, therefore, not to be taken in a limiting sense.

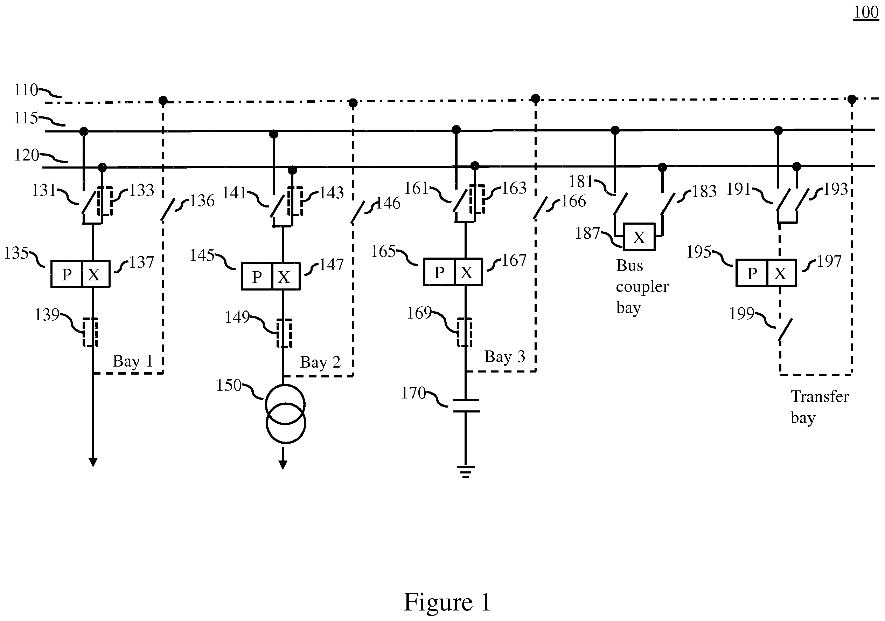

Figure 1 illustrates a multiphase electrical system 100. The multiphase electrical system 100 includes a plurality of bays (shown in the figure 1 as Bay 1, Bay 2 and Bay 3). Each bay includes an electrical subsystem which can be connected to any bus from a plurality of electrical buses (shown in the figure as bus 110, bus 115 and bus 120). Bus 115 and Bus 120 are main buses and bus 110 is a transfer bus used for maintenance purposes.

Bay 1 includes a transmission line (not shown in figure) as subsystem connected in the bay section. A circuit breaker 137 is provided in bay 1 for protection and switching purposes. The circuit breaker 137 is connected to the bus 115 via isolator 131. The circuit breaker 137 can be connected to the bus 120 via isolator 133. The transmission line is connected to the circuit breaker 137 via an isolator 139. The transmission line can be connected to the transfer bus 110 directly using the isolator 136. Opening and closing of the circuit breaker 137 is operated by a point on wave controller 135 (also referred to as an intelligent electronic device 135).

Similarly, bay 2 includes a power transformer 150 as subsystem connected in the bay section. A circuit breaker 147 is provided in bay 2 for protection and switching purposes. The circuit breaker 147 is connected to the bus 115 via isolator 141. The circuit breaker 147 can be connected to the bus 120 via isolator 143. The power transformer 150 is connected to the circuit breaker 147 via an isolator 149. The power transformer 150 can be connected to the transfer bus 110 directly using the isolator 146. Opening and closing of the circuit breaker 147 is operated by a point on wave controller 145 (also referred to as an intelligent electronic device 145).

Similarly, bay 3 includes a capacitor bank 170 as subsystem connected in the bay section. The capacitor bank 170 is solid grounded. A circuit breaker 167 is provided in bay 3 for protection and switching purposes. The circuit breaker 167 is connected to the bus 115 via isolator 161. The circuit breaker 167 can be connected to the bus 120 via isolator 163. The capacitor bank 170 is connected to the circuit breaker 167 via an isolator 169. The capacitor bank 170 can be connected to the transfer bus 110 directly using the isolator 166. Opening and closing of the circuit breaker 167 is operated by a point on wave controller 165 (also referred to as an intelligent electronic device 165).

In addition to the above mentioned bays, the electrical system 100 includes a bus coupler bay used for connecting or coupling the main buses (bus 115 and bus 120) together. The bus coupler bay includes a circuit breaker 187 which can be connected to bus 115 using an isolator 181 and can be connected to bus 120 using an isolator 183. Connection between both the main buses (bus 115 and bus 120) can be achieved by closing the isolators 181 and 183, and by closing the circuit breaker 187.

Similarly, the electrical system 100 includes a transfer bay used for transferring a subsystem from a main bus (bus 115 or bus 120) to the transfer bus 110. The transfer bay includes a circuit breaker 197 for protection and switching purposes. The circuit breaker 197 can be connected to the transfer bus via isolator 199. Similarly, the circuit breaker 197 can be connected to either of the main bus 115 via isolator 191 or main bus 120 via isolator 193. Opening and closing of the circuit breaker 197 is operated by a point on wave controller 195 (also referred to as an intelligent electronic device 195).

The point on wave controllers 135, 145,165 and 195 are used to determine appropriate switching instances for operating the corresponding circuit breakers to ensure minimal electrical disturbance in the electrical system 100, and to ensure that electrical and mechanical shock generated while switching are minimal. The point on wave controllers 135, 145, 165 and 195 are communicatively coupled to each other using a common communication channel or a dedicated bus. In an embodiment, the point on wave controllers (135, 145, 165 and 195) are configured to receive information relating to the state or position of isolators on a common communication bus based on a substation communication standard such as IEC 61850 GOOSE or on a dedicated communication bus.

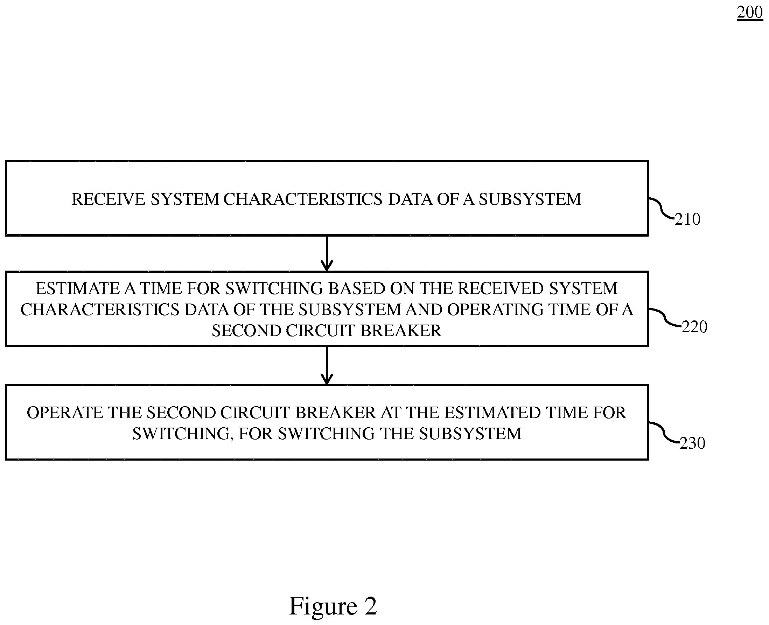

In an embodiment, the point on wave controller (135, 145, 165 or 195) includes one or more processors for computation and estimation of a time for switching, a memory module functionally coupled to the one or more processors for storing information required to perform estimation of the time for switching, and a network interface capable of communicating over an IEC 61850 communication channel. The network interface of the point on wave controller (135, 145, 165 or 195) is configured to receive information (referred to as system characteristics data) about the electrical subsystem (transmission line, power transformer 150 or capacitor bank 170) to which the corresponding circuit breaker is connected. The one or more processors of the point on wave controller (135, 145, 165 or 195) are configured to estimate the time for switching using the received information. These aspects are further explained in reference to figure 2.

It is to be noted by a person skilled in the art that while the figure 1 shows three buses (main buses: bus 115 and bus 120, and transfer bus: bus 110), there can be a plurality of buses (both main and transfer) in the multiphase electrical system 100. Additionally, it is to be noted by the person skilled in the art, while figure 1 is described with a separate transfer bus 110, any of the main buses can act as a transfer bus, thereby doing away with the need for a separate transfer bus. Similarly, it is to be noted by a person skilled in the art that while the figure 1 shows three bays (bay 1, bay 2 and bay 3) with three subsystems (transmission line, power transformer 150 and capacitor bank 170), there can be a plurality of bays with a plurality of subsystems such as shunt reactors, motor loads, generator sets, etc., which are capable of drawing power or feeding power to the buses. The plurality of subsystems can be grounding using a plurality of grounding configurations such as solid grounding, ungrounded, dynamic grounding (referred herein dynamic grounding refers to a grounding configuration where the grounding of the subsystem is subject to change based on the requirements of the multiphase electrical system 100), etc. Additionally, it is to be noted by a person skilled in the art that while communication in respect of the point on wave controllers 135, 145, 165 and 195 is disclosed using IEC 61850 communication channel or a dedicated bus, there can a plurality of similar networks and corresponding network configurations known to the person skilled in art which can be used for communication among the point on wave controllers 135, 145, 165 and 195. Similarly, it is to be noted by a person skilled in the art that while figure 1 discloses circuit breakers (137, 147, 167, 187 and 197), similar switching devices can also be used in place of the circuit breakers.

Figure 2 is a flowchart 200 of a method of performing point on wave switching in the multiphase electrical system 100. For the sake of clarity, the method is explained using two examples: a first example in relation to the capacitor bank 170 and a second example in relation to the power transformer 150.

In the first example, the circuit breaker 167 is scheduled for repair. Therefore, the capacitor bank 170 is disconnected from the circuit breaker 167 vis-a vis bus 120 and is transferred to bus 110. The transfer of capacitor bank 170 from bus 120 to bus 110 is achieved in the following manner. The bus 120 is coupled with bus 110 by closing the isolators 199 and 193 of the transfer bay along with the circuit breaker 197 of the transfer bay, and the isolator 166 of the bay 3. Due to coupling parallel voltages are created in both the buses (bus 120 and bus 110). Subsequently, the circuit breaker 167 is opened, and then the isolators 163 and 169 are opened, thereby disconnecting the capacitor bank 170 from the bus 120, thereby effectively transferring the capacitor bank 170 from bus 120 to bus 110. It is to be noted by a person skilled in the art that while the abovementioned example describes a typical online transfer, the transfer can be achieved using any other philosophy.

On receiving a signal indicative of the transfer of the capacitor bank 170 from bus 120 to bus 110, the point on wave controller 165 transmits system characteristics data of the capacitor bank 170 to the point on wave controller 195. In an embodiment, the signal indicative of transfer refers to the information relating to the state or position of isolators 161, 169, 191 and 199. In another embodiment, signal indicative of transfer refers to a signal issued by an operator (using a workstation or an actuator) of the electrical system 100. In an embodiment, a SCADA (supervisory control and data acquisition) system (not shown in figure) is utilized for initiation of transfer of the subsystem. An operator of the SCADA system informs the SCADA system that a transfer has to be perfomed. Subsequently, the SCADA system transmits a transfer-send command to the point on wave controller 135. On receiving a transfer command, the point on wave controller 135 transmits system characteristics data of the subsystem to the SCADA system. Upon successfully receiving, the system characteristics data of subsystem, the SCADA system transmits a transfer-receive command to the point on wave controller 195 of the transfer bay. The point on wave controller 195 responds by sending a ready for transfer notification to the SCADA system. Upon receiving the ready fo transfer notification from the point on wave controller 195, the SCADA system transmits the system characteristics data to the point on wave controller 195.

System characteristics data herein refers to information about all parameters relating to the subsystem (capacitor bank 170 in the first example) that are utilized in estimation of time for switching and in switching strategy. System characteristics data includes, but is not limited to, type of subsystem, grounding configuration of the subsystem, an order in which the phases of the subsystem were disconnected, lead operating phase associated with the subsystem, polarity sensitivity preference associated with the subsystem, a correction factor associated with subsystem, residual flux or trapped charges associated with the subsystem.

In the first example, the point on wave controller 165 transmits to the point on wave controller 195 the type of subsystem as capacitor bank, the grounding configuration as solidly grounded, the order of phase disconnection as L1 phase, L2 phase, and L3 phase, lead operating phase as L1 phase, polarity sensitivity preference of 1(i.e. 1 indicative of the subsystem being polarity sensitive and 0 being indicative of the subsystem being polarity insensitive) associated the capacitor bank 170. It is to be noted by a person skilled in the art that while the polarity sensitivity preference has been indicated as 0 or 1, various other combinations and values are possible.

At step 210, the point on wave controller 195 receives the system characteristics data of the capacitor bank 170 from the point on wave controller 165. Subsequently, the point on wave controller 195 is to perform switching of the capacitor bank 170.

At step 220, the point on wave controller 195 estimates the time for switching based on the received system characteristics data of the capacitor bank 170 and the operating time of the circuit breaker 197. In an embodiment, the point on wave controller 195 utilises additional information relating spring energy of an operating mechanism of the circuit breaker 197, drive pressure of the operating mechanism of the circuit breaker 197, ambient temperature around the circuit breaker 197 for estimating time for switching. Similarly, the point on wave controller determines the switching strategy to be used based on the system characteristics data of the capacitor bank 170. Since the type of subsystem is a capacitor bank, uncontrolled energization will lead to inrush currents and overvoltages. Therefore, the point on wave controller 195 determines appropriate switching instance as when the voltage in the bus 110 is zero (i.e. zero point crossing) and accordingly estimate the time for switching. The lead operating phase determines which phase has to be switched first. Since the lead operating phase of the capacitor bank 170 is L1 phase, the point on wave controller 197 estimates the time for switching where the first phase to be switched is L1. Similarly, the grounding configuration and the polarity sensitivity preference of the capacitor bank 170 determine the phase angles at which the switching can happen and therefore, in turn determine the time for switching. Since the grounding configuration of the capacitor bank 170 is solidly grounded and the polarity sensitivity preference is 1, the point on wave controller 195 estimates the time for switching where the phase angles are 0 degree for L1 phase, 120 degrees for L2 phase and 240 degrees for L3 phase. Based on the order of sequence L1, L2, and L3, the point on wave controller determines a switching strategy where the order of sequence is retained.

Upon estimating the time for switching at step 230, the point on wave controller 195 operates the circuit breaker 197 at the time for switching, for switching the subsystem i.e. the capacitor bank 170. At the time for switching, the controller 195 issues the command for close or open to the circuit breaker 137. Due to the operating time of the circuit breaker 137, the closing or opening operation is complete at appropriate time instance at which zero point crossing occurs.

In the second example, a fault occurs in the circuit breaker 147 during the switching of the power transformer 150. Residual flux persists (corresponding to angle of α at phase L1, β at phase L2, and θ at phase L3) in the power transformer 150.,Subsequently, using an offline transfer philosophy, the power transformer 150 is transferred from the bus 120 to bus 110.

Upon receiving a signal indicative of transfer, the point on wave controller 145 transmits to the point on wave controller 195 the system characteristics data of the power transformer 150: the type of subsystem as transformer, the grounding configuration as dynamic grounding, the order of phase disconnection as L1 phase, L2 phase, and L3 phase, lead operating phase as L1 phase, polarity sensitiveness preference of 0 associated with the power transformer 150, a residual flux value (of greater than 0) associated with the power transformer 150 at a disconnected state.

At step 210, the point on wave controller 195 receives the system characteristics data of the power transformer 150 from the point on wave controller 145. Subsequently, the point on wave controller 195 is to perform switching of the power transformer 150.

At step 220, the point on wave controller 195 estimates the time for switching based on the received system characteristics data of the power transformer 150 and the operating time of the circuit breaker 197. Similarly, the point on wave controller determines the switching strategy to be used based on the system characteristics data of the power transformer 150.

Since the type of subsystem is a power transformer and residual flux value is greater than zero, uncontrolled energization will lead to overfluxing of core of the power transformer 150 and heavy inrush currents capable of stressing windings of the power transformer 150. Therefore, the point on wave controller 195 determines appropriate switching instance as when the voltage in the bus 110 is capable of inducing a prospective flux in the power transformer 150 for canceling out the residual flux, and accordingly estimate the time for switching. The lead operating phase determines which phase has to be switched first. Since the lead operating phase of the power transformer 150 is L1 phase, the point on wave controller 197 estimates the time for switching where the first phase to be switched is L1. Similarly, the grounding configuration and the polarity sensitivity preference of the power transformer 150 determine the phase angles at which the switching can happen and therefore, in turn determine the time for switching. Since the grounding configuration of the power transformer 150 is dynamic grounding which for example is solidly grounded, and the polarity sensitivity preference is 0, the point on wave controller 195 estimates the time for switching where the phase angles are 0 + α degree for L1 phase, 120+ β degrees for L2 phase and 60+ θ degrees for L3 phase. Based on the order of sequence L1, L2, and L3, the point on wave controller determines a switching strategy where the order of sequence is retained.

Upon estimating the time for switching at step 230, the point on wave controller 195 operates the circuit breaker 197 at the time for switching, for switching the subsystem i.e. the power transformer 150. At the time for switching, the controller 195 issues the command for close or open to the circuit breaker 197. Due to the operating time of the circuit breaker 197, the closing or opening operation is complete at appropriate time instance at which residual flux is negated.

In an embodiment, the method further includes subscribing, by the point on wave controller 195, to a data stream of a measurement sensor associated with the subsystem upon receiving the system characteristics data or upon receiving information indicative of transfer initiationMeasurement sensor herein refers to any sensor or device which is capable of measuring one or more parameters of the subsystem. Measurement sensor includes, but is not limited to, voltage transformer, current transformer, etc. In an embodiment, the measurement sensor is a voltage transformer connected to the subsystem. In an embodiment, a merging unit is utilized to convert the analog readings of the measurement sensor to digital data stream. The point on wave controller utilizes the data stream of the measurement sensor in estimation of the time for switching.

In an embodiment, the system characteristics data of the subsystem is transmitted to the point on wave controller 195 from a central repository. In an embodiment, the central repository resides on the SCADA system. The central repository is communicatively coupled using a communication network or bus with the point on wave controllers 135, 145, 165 and 195. The central repository receives system characteristics data of the subsystems corresponding to the controllers and stores the system characteristics data of the subsystems. In an embodiment, the central repository is configured to assist the point on wave controllers 135, 145, 165 and 195 in estimation of time for switching by providing a computation platform.

In an embodiment, the system characteristics data includes a correction factor associated with the subsystem. For example, a correction factor of 1 milliseconds is used relation to the capacitor bank 170. When the point on wave controller notices an error in time for switching, the point on wave controller utilizes the correction factor to correct the time for switching in the next estimation. The error correction process is iteratively performed.

It is to be noted by a person skilled in the art while the method is explained using the capacitor bank 170 and the power transformer 150, the method can be applied to a plurality of subsystems. Similarly, it is to be noted by a person skilled in the art, that switching herein refers to closing or opening of the subsystem connection using a circuit breaker. Additionally, the method can be used to transit system characteristics with corrections from the point on wave controller 195 to the other point on wave controllers upon from transfer of the subsystem back to the main bus.

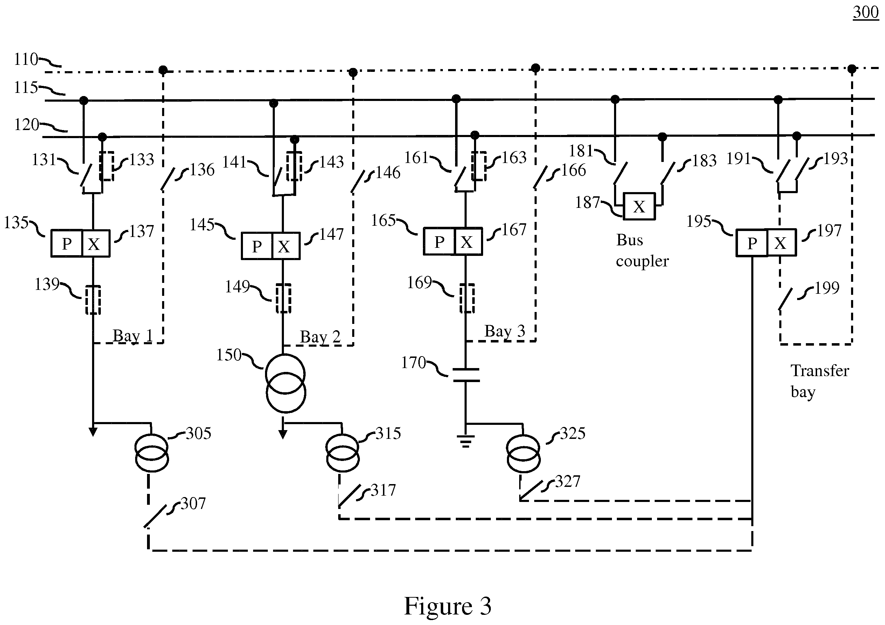

Figure 3 illustrates a multiphase electrical system 300. The capabilities and components of the multiphase electrical system 300 is similar to the multiphase electrical system 100. Additionally, the multiphase electrical system 300 includes one or more voltage transformers 305, 315 and 325, connected to the transmission line, power transformer 150 and the capacitor bank 170 respectively. The voltage transformers 305, 315 and 325 can be connected to the point on wave controller 195 via isolators 307, 317 and 327 respectively. The voltage transformers are configured to publish voltage information about the subsystems over a common communication bus or a dedicated hardwired line. The point on wave controller 195 utilizes the publish voltage information about the subsystem to the corresponding circuit breaker 197 is connected to estimate the time for switching in addition to the system characteristics data.

This written description uses examples to describe the subject matter herein, including the best mode, and also to enable any person skilled in the art to make and use the subject matter. The patentable scope of the subject matter is defined by the claims, and may include other examples that occur to those skilled in the art. Such other examples are intended to be within the scope of the claims if they have structural elements that do not differ from the literal language of the claims, or if they include equivalent structural elements with insubstantial differences from the literal language of the claims.

## Claims

1. A method of performing point on wave switching in a multiphase electrical system (100) having a first circuit breaker (137) connected to a first bus (120), the first circuit breaker (137) operated by a first controller (135), a second circuit breaker (197) connected to a second bus (110), the second circuit breaker (197) operated by a second controller (195), and a subsystem transferred from the first bus (120) to the second bus (110), the method comprising:
a. receiving (210), by the second controller (195), system characteristics data of the subsystem;
**characterized in that** the method further comprises:
b. estimating (220), by the second controller (195), a time for switching based on the received system characteristics data of the subsystem and operating time of the second circuit breaker (197);
c. operating (230), by the second controller (195), the second circuit breaker (197) at the estimated time for switching, for switching the subsystem,
wherein the system characteristics data is transmitted from one or more subsystem data sources, upon receiving a signal from at least one of an isolator (131, 169, 191, 199) connected between the circuit breaker and the bus and an operator, and
wherein the one or more subsystem data sources includes the first controller (135).

2. The method as claimed in claim 1, the method further comprising subscribing, by the second controller (195), to a data stream of a measurement sensor (305) associated with the subsystem.

3. The method as claimed in claim 1 or 2, wherein the one or more subsystem data sources includes a central data repository, wherein the central data repository is communicatively coupled to one or more controllers for receiving switching information from the one or more controllers.

4. A controller (195) for operating a circuit breaker (197) connected to a second bus (110) for switching a subsystem, wherein the subsystem is transferred from a first bus (120) to a second bus (110), the controller (195) comprising:
a. one or more processors configured to receive system characteristics data of the subsystem, estimate a time for switching based on the received system characteristics data of the subsystem and operating time of the circuit breaker (197), and operate the circuit breaker (197) at the estimated time for switching, for switching the subsystem; and
b. a memory module functionally coupled to the one or more processors,
**characterized in that**
the controller (195) includes a network interface configured to communicate over an IEC 61850 channel for receiving the system characteristics data from one or more system data sources,
wherein the one or more system data sources includes at least one of a first controller (135) functionally coupled to a circuit breaker (137) of the first bus (120) and a central repository.

5. The controller (195) as claimed in claim 4, wherein the one or more processors are further configured to subscribe a data stream of a measurement sensor (305) associated with the subsystem.

## Patentansprüche

1. Verfahren zum Durchführen einer Schaltung auf der Spannungswelle in einem mehrphasigen elektrischen System (100) mit einem ersten Leistungsschalter (137), der an eine erste Sammelschiene (120) angeschlossen ist, wobei der erste Leistungsschalter (137) durch eine erste Steuerung (135) betätigt wird, einem zweiten Leistungsschalter (197), der an eine zweite Sammelschiene (110) angeschlossen ist, wobei der zweite Leistungsschalter (197) durch eine zweite Steuerung (195) betätigt wird, und einem Subsystem, das ausgehend von der ersten Sammelschiene (120) auf die zweite Sammelschiene (110) übertragen wird, wobei das Verfahren umfasst:
a. Empfangen (210), und zwar durch die zweite Steuerung (195), von Systemcharakteristikdaten des Subsystems;
**dadurch gekennzeichnet, dass** das Verfahren darüber hinaus umfasst:
b. Schätzen (220), und zwar durch die zweite Steuerung (195), einer Zeit zur Schaltung auf Grundlage der empfangenen Systemcharakteristikdaten des Subsystems und einer Betätigungszeit des zweiten Leistungsschalters (197);
c. Betätigen (230), und zwar durch die zweite Steuerung (195), des zweiten Leistungsschalters (197) zur geschätzten Zeit zur Schaltung, um das Subsystem zu schalten,
wobei die Systemcharakteristikdaten ausgehend von einer oder mehreren Subsystemdatenquelle/n beim Empfang eines Signals ausgehend von einem Trennschalter (131, 169, 191, 199), der zwischen dem Leistungsschalter und der Sammelschiene angeschlossen ist, und/oder einer Bedienperson übertragen werden, und
wobei die eine oder die mehreren Subsystemdatenquelle/n die erste Steuerung (135) umfasst bzw. umfassen.

2. Verfahren nach Anspruch 1, wobei das Verfahren darüber hinaus umfasst, sich durch die zweite Steuerung (195) bei einem Datenstrom eines Messsensors (305) anzumelden, der dem Subsystem zugeordnet ist.

3. Verfahren nach Anspruch 1 oder 2, wobei die eine oder die mehreren Subsystemdatenquelle/n einen zentralen Datenspeicher umfasst bzw. umfassen, wobei der zentrale Datenspeicher kommunikationstechnisch mit einer oder mehreren Steuerung/en verbunden ist, um Schaltinformationen ausgehend von der einen oder den mehreren Steuerung/en zu empfangen.

4. Steuerung (195) zum Betätigen eines an eine zweite Sammelschiene (110) angeschlossenen Leistungsschalters (197) zur Schaltung eines Subsystems, wobei das Subsystem ausgehend von einer ersten Sammelschiene (120) zu einer zweiten Sammelschiene (110) übertragen wird, wobei die Steuerung (195) umfasst:
a. einen oder mehrere Prozessor/en, der bzw. die dazu konfiguriert ist bzw. sind, Systemcharakteristikdaten des Subsystems zu empfangen, eine Zeit zur Schaltung auf Grundlage der empfangenen Systemcharakteristikdaten des Subsystems und einer Betätigungszeit des Leistungsschalters (197) zu schätzen, und den Leistungsschalter (197) zur geschätzten Zeit zur Schaltung zu betätigen, um das Subsystem zu schalten; und
b. eine Speichermodul, das funktional an den einen oder die mehreren Prozessor/en angeschlossen ist,
**dadurch gekennzeichnet, dass**
die Steuerung (195) eine Netzschnittstelle umfasst, die dazu konfiguriert ist, über einen IEC 61850-Kanal zu kommunizieren, um die Systemcharakteristikdaten ausgehend von einer oder mehreren Systemdatenquelle/n zu empfangen,
wobei die eine oder die mehreren Systemdatenquelle/n eine funktional an einen Leistungsschalter (137) der ersten Sammelschiene (120) angeschlossene erste Steuerung (135) und/oder einen zentralen Speicher umfasst.

5. Steuerung (195) nach Anspruch 4, wobei der eine oder die mehreren Prozessor/en darüber hinaus dazu konfiguriert ist bzw. sind, sich bei einem Datenstrom eines Messsensors (305) anzumelden, der dem Subsystem zugeordnet ist.

## Revendications

1. Procédé permettant d'effectuer un point de commutation d'onde dans un système électrique multiphase (100) comportant un premier disjoncteur (137) connecté à un premier bus (120), le premier disjoncteur (137) étant actionné par un premier dispositif de commande (135), un deuxième disjoncteur (197) connecté à un deuxième bus (110), le deuxième disjoncteur (197) étant actionné par un deuxième dispositif de commande (195), et un sous-système transféré du premier bus (120) au deuxième bus (110), le procédé comprenant :
a. la réception (210), par le deuxième dispositif de commande (195), de données caractéristiques de système du sous-système ;
**caractérisé en ce que** le procédé comprend en outre :
b. l'estimation (220), par le deuxième dispositif de commande (195), d'un temps de commutation sur la base des données caractéristiques de système reçues du sous-système et d'un temps d'actionnement du deuxième disjoncteur (197) ;
c. l'actionnement (230), par le deuxième dispositif de commande (195), du deuxième disjoncteur (197) au temps de commutation estimé, pour la commutation du sous-système,
sachant que les données caractéristiques de système sont transmises depuis une ou plusieurs sources de données de sous-système, lors de la réception d'un signal depuis au moins l'un d'un isolateur (131, 169, 191, 199) connecté entre le disjoncteur et le bus et d'un opérateur, et
sachant que l'une ou les plusieurs sources de données de sous-système incluent le premier dispositif de commande (135).

2. Le procédé tel que revendiqué dans la revendication 1, le procédé comprenant en outre l'abonnement, par le deuxième dispositif de commande (195), à un flux de données d'un capteur de mesure (305) associé au sous-système.

3. Le procédé tel que revendiqué dans la revendication 1 ou 2, sachant que l'une ou les plusieurs sources de données de sous-système incluent un référentiel de données central, sachant que le référentiel de données central est couplé en termes de communication à un ou plusieurs dispositifs de commande pour recevoir des informations de commutation depuis l'un ou les plusieurs dispositifs de commande.

4. Dispositif de commande (195) permettant d'actionner un disjoncteur (197) connecté à un deuxième bus (110) pour la commutation d'un sous-système, sachant que le sous-système est transféré d'un premier bus (120) à un deuxième bus (110), le dispositif de commande (195) comprenant :
a. un ou plusieurs processeurs configurés pour recevoir des données caractéristiques de système du sous-système, estimer un temps de commutation sur la base des données caractéristiques de système reçues du sous-système et un temps d'actionnement du disjoncteur (197), et actionner le disjoncteur (197) au temps de commutation estimé, pour la commutation du sous-système ; et
b. un module de mémoire couplé fonctionnellement à l'un ou aux plusieurs processeurs,
**caractérisé en ce que**
le dispositif de commande (195) inclut une interface de réseau configurée pour communiquer via un canal CEI 61850 afin de recevoir les données caractéristiques de système depuis une ou plusieurs sources de données de système,
sachant que l'une ou les plusieurs sources de données de système incluent au moins l'un d'un premier dispositif de commande (135) couplé fonctionnellement à un disjoncteur (137) du premier bus (120) et d'un référentiel central.

5. Le dispositif de commande (195) tel que revendiqué dans la revendication 4, sachant que l'un ou les plusieurs processeurs sont en outre configurés pour s'abonner à un flux de données d'un capteur de mesure (305) associé au sous-système.
